# EUROPÄISCHE PATENTSCHRIFT

(11) **EP 1 286 803 B1**
(45) Veröffentlichungstag und Bekanntmachung des Hinweises auf die Patenterteilung: **20.07.2005**
(21) Anmeldenummer: 01935995.9
(22) Anmeldetag: 26.04.2001
(51) Int. Cl.: B23K 1/00, B23K 3/08, B23K 37/04, F28D 9/00

(54) **VERFAHREN ZUR HERSTELLUNG EINES BAUELEMENTS AUS ÜBEREINANDER GESTAPELTEN MITEINANDER VERLÖTETEN PLATTEN**
METHOD FOR PRODUCING A STRUCTURAL MEMBER FROM PLATES STACKED ON TOP OF EACH OTHER AND SOLDERED TOGETHER
PROCEDE DE PRODUCTION D'UN ELEMENT DE CONSTRUCTION A PARTIR DE PLAQUES EMPILEES LES UNES SUR LES AUTRES ET BRASEES LES UNES AUX AUTRES

(30) Priorität: 18.05.2000 DE 10024111
(43) Veröffentlichungstag der Anmeldung: 05.03.2003
(73) Patentinhaber: ROBERT BOSCH GMBH, 70442 Stuttgart (DE)
(72) Erfinder: RESCHNAR, Wilfried, 74360 Schozach (DE); BORGES, Stephan, 71640 Ludwigsburg (DE); LEUTHNER, Stephan, 70372 Stuttgart (DE); HACKENBERG, Juergen, 74343 Sachsenheim (DE); WETZL, Franz, 74395 Mundelsheim (DE)
(86) Internationale Anmeldenummer: PCT/DE2001/001570
(87) Internationale Veröffentlichungsnummer: WO 2001/087529

(56) Entgegenhaltungen:
- EP-A- 0 689 023
- EP-A- 0 907 064
- EP-A- 1 094 291
- WO-A-01/30528
- DE-C- 19 801 374
- US-A- 2 961 222
- US-A- 4 128 235
- US-A- 4 249 597
- US-A- 5 811 168

## Beschreibung

Die Erfindung betrifft ein Verfahren zur Herstellung eines Bauelements aus übereinander gestapelten miteinander verlöteten Platten nach dem Oberbegriff des Anspruchs 1 (siehe, z.B., DE-C-198 01 374).

### Stand der Technik:

Mikro-Wärmeübertrager eignen sich zum Beispiel für die Anwendung in Klimakreisläufen. Des Weiteren können Mikro-Wärmeübertrager bei der Kühlung von elektronischen Bauelementen, zum Beispiel in der Leistungselektronik eingesetzt werden.

Zur Massen- und/oder Volumenreduzierung insbesondere in Fahrzeugen ist eine kompakte Herstellung des Wärmeübertragers gewünscht. Bei einigen Ausführungsformen werden hierzu Platten, in denen Kanäle eingebracht sind, zu kompletten Bauteilen zusammengefügt. Die Kanalstrukturen können auftragend oder abtragend hergestellt werden. Bei einer abtragenden Herstellung werden aus einem Material entsprechende Kanäle herausgefräst, geätzt oder beispielsweise durch Laserbearbeitung erzeugt. Hierdurch können Kanalstrukturen hergestellt werden, in denen ein Fluid strömen kann. Bei der aufbauenden Herstellung werden Strukturen auf einen Träger aufgebaut, zum Beispiel durch einen Galvanisierungsschritt. Das Zusammenfügen von einzelnen Platten erfolgt regelmäßig durch Lötverfahren. Das Anbringen von Anschlüssen kann dabei nicht immer in einem Fertigungsvorgang erledigt werden.

Aus der DE 198 01 374 C1 ist ein Verfahren zum Löten von metallischen, mikrostrukturierten Blechen offenbart. Bei diesem Verfahren wird aus den Blechen sowie Lötschichten, die jeweils zwischen zwei benachbarten Blechen vorhanden sind, ein Stapel erzeugt und unter Druckbeaufschlagung im Vakuum öder in Intergas-Atmosphäre einem Lötdiffusionsprozeß unterzogen. Dies erfolgt in einem entsprechend hermetisch geschlossenen Ofen. Bei diesem Vorgang ist insbesondere die Beaufschlagung eines Stapels aus mikrostrukturierten Blechen mit Druck vergleichsweise aufwendig. Denn geeignete Presswerkzeuge werden mit den herzustellenden Bauteilen auf die Löttemperatur aufgeheizt und müssen daher diesen Temperaturen auch standhalten können.

### Aufgabe und Vorteile der Erfindung:

Der Erfindung liegt die Aufgabe zugrunde, die Herstellung von Bauelementen der einleitend bezeichneten Art zu vereinfachen.

Diese Aufgabe wird durch die Merkmale des Anspruchs 1 gelöst.

In den Unteransprüchen sind vorteilhafte und zweckmäßige Weiterbildung der Erfindung angegeben.

Die Erfindung geht von einem Verfahren zur Herstellung eines Bauelements aus übereinander gestapelten miteinander verlöteten Platten, in welche wenigstens teilweise Ausnehmungen, vorzugsweise zur Ausbildung von Kanälen, eingebracht sind, aus, bei welchem zwischen den Platten für einen Lötdiffusionsprozess wenigstens eine Lötschicht vorgesehen wird. Der Lötdiffusionsprozess wird günstiger Weise im Vakuum oder in Intergas-Atmosphäre ausgeführt. Der Kern der Erfindung liegt nun darin, dass die Platten mit dazwischen liegenden Lotschichten übereinander gestapelt und vor dem Lötdiffusionsprozess mit Presswerkzeugen verpresst werden und dass nach dem Pressen der verpresste Stapel von Platten ohne die Presswerkzeuge in einem Ofen für den Lötdiffusionsprozess verbracht und auf Löttemperatur aufgeheizt wird. Die Erfindung macht sich dabei die Erkenntnis zu Nutze, dass eine ausreichend gute Verbindung der einzelnen Platten beim Lötdiffusionsprozess schon dann erzielt werden kann, wenn ein Verpressen der Platten vor dem eigentlichen Lötdiffusionsvorgang durchgeführt wird, was ein vergleichsweise starkes Verpressen der Platten beim Lötdiffusionsprozess unter Temperatur entbehrlich macht. Damit kann auf aufwendige Presswerkzeuge verzichtet werden, die ansonsten den hohen Löttemperaturen standhalten müssten.

In einer besonders bevorzugten Ausgestaltung der Erfindung wird der Stapel aus Platten und Lotschichten während des Lötdiffusionsvorgangs mit einem Gewicht, zum Beispiel einem Stahlblock, beschwert, das einer Kraft entspricht, die kleiner als die beim Verpressen erforderliche Presskraft ist. Durch das Vorverpressen kann beim eigentlichen Lötdiffusionsvorgang häufig nicht gänzlich auf ein Aneinanderdrücken der Platten verzichtet werden. Allerdings ist eine vergleichsweise kleine Presskraft bereits ausreichend, die mit einem Auflagegewicht bereit gestellt werden kann, das normalerweise zum Aufbringen einer notwendigen Anpresskraft ohne Vorverpressen nicht ausreichen würde.

In einer weiteren besonders bevorzugten Ausgestaltung der Erfindung wird der Stapel aus Platten und Lötschichten für den Lötdiffusionsprozess in eine Aufnahme eingelegt. Durch diese Maßnahme wird eine sichere Positionierung des Plattenstapels beim Lötvorgang gewährleistet. Vorzugsweise ist die Auflagefläche der Aufnahme derart beschichtet, dass eine Verbindung der Oberfläche der Aufnahme mit dem zu lötenden Plattenstapel vermieden wird.

Um die Trennung zwischen Aufnahme und zu lötendem Plattenstapel weiter zu verbessern, wird überdies vorgeschlagen, dass zwischen Aufnahme und Plattenstapel ein hochtemperaturfestes Isolationsmaterial eingelegt wird.

Um zu vermeiden, dass ein bereits gelöteter Plattenstapel bei der unmittelbaren Anbringung von zum Beispiel Anschlüssen durch ein nachfolgenden Lötprozess beeinträchtigt wird, wird überdies vorgeschlagen, dass der nachfolgende Lötprozess bei einer niedrigeren Temperatur ausgeführt wird als der vorangegangene Lötprozess.

Für eine rationelle Fertigung und zur Gewährleistung einer sicheren Lötverbindung wird überdies vorgeschlagen, dass auf die Platten vor dem Verpressen und Verlöten eine Lötschicht aufgebracht wird, zum Beispiel eine Bronzeschicht in einem elektrolytischen Verfahren. Dabei ist für einen nachfolgenden Lötprozess unter Unterdruckbedingungen darauf zu achten, dass die Beschichtung ein möglichst geringen Glanzgrad aufweist, um Ausgasungen zu vermeiden. Neigt die Beschichtung beim Kontakt mit Luft zu Oxidation, werden vorzugsweise hierbei entstandene Oxidationsprodukte vor dem Lötvorgang zum Beispiel durch Eintauchen in eine geeignete Lösung entfernt.

In einer außerdem bevorzugten Ausgestaltung der Erfindung werden die Platten durch eine photolitographischen Strukturierungsprozess mit nachfolgendem Ätzprozess mit Ausnehmungen versehen, um zum Beispiel Strömungskanäle herzustellen.

### Zeichnungen:

Die Erfindung wird anhand der nachfolgenden Zeichnungen unter Angabe weiterer Vorteile und Einzelheiten näher erläutert.

Es zeigen
- Fig. 1a-f: die Herstellung einer strukturierten Platte für zum Beispiel einen Mikro-Wärmeübertrager in einzelnen Prozessstadien anhand von schematischen Schnittansichten,
- Fig. 2a+b: zwei strukturierte und beschichtete Platten, die die Prozessschritte gemäß Fig. 1a-f durchlaufen haben in einer Draufsicht,
- Fig. 3: übereinander gestapelte Platten in einer Aufnahme mit Anpressgewicht schematisch dargestellt und
- Fig. 4a+b: einen fertig gelöteten Mikro-Wärmeübertrager in einer perspektivischen Ansicht bzw. einen vergrößerten Ausschnitt davon.

### Beschreibung der Ausführungsbeispiele:

Ein Wärmeübertrager besteht aus übereinander gestapelten einzelnen Platten (Blechen) aus zum Beispiel Kupfer, Aluminium oder ähnlichem, in die Kanalstrukturen und ggf. Hilfsstrukturen für die Positionierung eingebracht sind. Die Dicke der einzelnen Lagen kann über einen weiten Bereich variieren, ebenso die Tiefe und die Breite der Kanäle. Je nach Fertigungsverfahren erhält man rechteckförmige oder nicht rechteckförmige Kanäle.

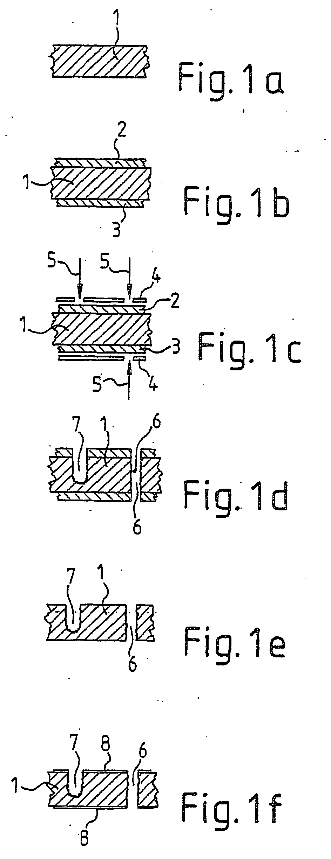

In den Figuren 1a-f ist beispielhaft die Herstellung einer strukturierten Platten verdeutlicht, die für einen nachfolgenden Lötdiffusionsprozess übereinander gestapelt werden kann. Auf ein Substrat 1 wird beidseitig ein Trocken-Fotolackfilm 2, 3 laminiert. Mit Hilfe einer Maske, zum Beispiel Folienmaske 4 wird der lichtempfindliche Film 2, 3 durch UV-Strahlung (durch Pfeile 5 schematisch dargestellt) belichtet. Für die bei der Herstellung der Kanalstrukturen im Allgemeinen benötigte Genauigkeit sind kostengünstige Folienmasken und eine Kontaktbelichtung regelmäßig ausreichend. Der belichtete Fotolackfilm 2, 3 wird in einen geeigneten Entwicklermedium strukturiert. Dabei werden Bereiche von späteren Kanälen frei gelegt. Für die Vereinzelung der Teile wird der Fotolackfilm nicht nur beidseitig auf das Substrat aufgebracht, sondern auch beidseitig belichtet und entwickelt, wobei bei gleichzeitigem Ätzen von Ober- und Unterseite an gegenüberliegenden Stellen 6 das Substrat vollständig durchtrennt wird (Fig. 1d). Entsprechend des verwendeten Ätzmediums, das beispielsweise ein isotropes Ätzverhalten zeigt, entstehen keine rechteckigen Konturen, sondern verrundete Kanalquerschnitte 7.

Der Ätzprozess kann auf unterschiedliche Arten durchgeführt werden. Beim stromlosen Ätzabtragen erfolgt die Metallauflösung durch eine Redoxreaktion; das Metall wird hierbei oxidiert und aufgelöst. Dieses Verfahren wird üblicherweise für große Substratflächen verwendet. Im vorliegenden Fall sind auf dem Substrat viele Einzellagen für den herzustellenden Wärmeübertrager nebeneinander angeordnet. Das Ätzen kann zur kostengünstigen Herstellung im Durchlaufverfahren in einer Sprühätzanlage stattfinden.

Nach durchgeführtem Ätzprozess wird der Fotolackfilm 2, 3 entfernt (Fig. 1e).

Als nächster Bearbeitungsschritt erfolgt eine elektrolytische Beschichtung (Fig. 1f). Beispielsweise wird eine Bronzebeschichtung (CuSn₆) 8 beidseitig auf das Substrat 1 aufgebracht.

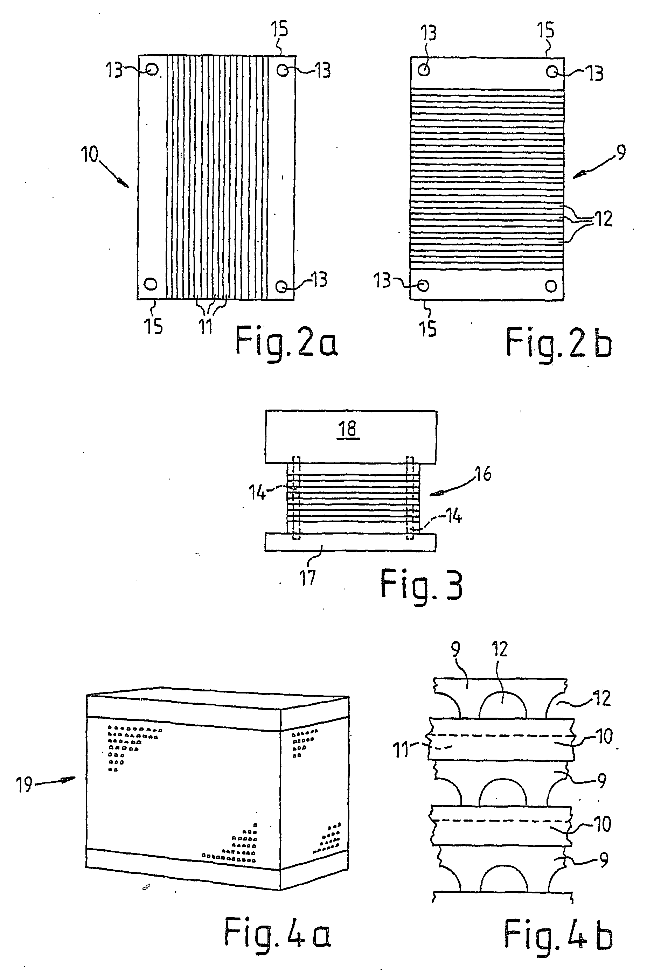

Eine Draufsicht auf entsprechend nach dem dargestellten Verfahrensablauf hergestellte strukturierte Platten 9, 10 ist in den Figuren 2a+b dargestellt. Die Platten 9, 10 sind rechteckig, wobei in die Platte 10 in Längsrichtung Strömungskanäle 11 und in die Platte 9 in Querrichtung Strömungskanäle 12 eingeätzt wurden, und zwar jeweils auf nur einer Seite. In den Platten 9, 10 wurden außerdem durch beidseitiges Ätzen Löcher 13 ausgebildet, mittels welcher sich die Platten 9, 10 alternierend und positionsexakt auf Führungsstifte 14 (s. Fig. 3) auffädeln lassen. Die Außenkontur der Platten 9, 10 ist ebenfalls durch beidseitiges Ätzen entstanden, wobei jedoch die Platten im Substrat durch Nasen 15 gehalten wurden, die ein ungewolltes mechanischen Ausbrechen während der einzelnen Prozessschritte verhinderten.

In Fig. 3 ist ein Stapel 16 von alternierend übereinander gestapelten Platten 9, 10 zwischen zwei Backen 17, 18 und auf Führungsstiften 14 aufgefädelt, dargestellt. Durch die obere Backe 18 wird der Plattenstapel 16 für den Lötdiffusionsprozess zur Verbindung der Platten mit etwas Druck beaufschlagt. Die Backe 18 dient also als Anpressgewicht. Entscheidung für das Gelingen der Lötdiffusionsvorgangs bei welchem die Bronzebeschichtung als Lot dient, ist ein Verpressvorgang des Stapels 14, vorzugsweise mit den Backen 17 und 18 in einer Presse, zum Beispiel Handpresse in kaltem Zustand vor dem eigentlichen Lötdiffusionsvorgang. Dadurch werden komplizierte Presswerkzeuge, die ansonsten mit in den Ofen zum Verlöten eingebracht und mit aufgeheizt werden müssten, vermieden. Nachdem Pressen kann der Plattenstapel 16 mit Backen 17, 18 in einfacher Weise ohne Presswerkzeuge in zum Beispiel einen Einkammervakuumofen verbracht werden, in welchem die Plattenstapel auf Löttemperatur aufgeheizt werden.

Nach einer Abkühlphase kann der fertig verlötete Plattenstapel 19 (s. Fig. 4a) für die Weiterverarbeitung aus dem Ofen wieder entnommen werden.

In Fig. 4b ist ein vergrößerte Ausschnitt des Plattenstapels mit alternierenden Platten 9, 10 und Strömungskanälen 12 dargestellt.

## Patentansprüche

1. Verfahren zur Herstellung eines Bauelements aus übereinander gestapelten, miteinander verlöteten Platten (9, 10), in welche wenigstens teilweise Ausnehmungen (11, 12, 13) eingebracht sind, bei welchem zwischen den Platten (9, 10) für einen Lötdiffusionsprozess wenigstens eine Lotschicht (8) vorgesehen wird, **dadurch gekennzeichnet, dass** die Platten (9, 10) mit dazwischen liegenden Lotschichten (8) übereinander gestapelt und vor dem Lötdiffusionsprozess mit einem Presswerkzeug verpresst werden und dass beim Lötdiffusionsprozess der Stapel aus Platten (9, 10) und Lotschichten (8) ohne Presswerkzeug oder nur mit einer zur Presskraft beim Vorverpressen vergleichsweise kleinen Presskraft beaufschlagt wird.

2. Verfahren nach Anspruch 1, **dadurch gekennzeichnet, dass** der Stapel aus Platten (9, 10) und Lotschichten (8) während des Lötdiffusionsvorgangs mit einem Gewicht beschwert wird, das einer Kraft entspricht, die kleiner als die beim Verpressen erforderliche Presskraft ist.

3. Verfahren nach Anspruch 1 oder 2, **dadurch gekennzeichnet, dass** der Stapel aus Platten (9, 10) und Lotschichten (8) für den Lötdiffusionsprozess in eine Aufnahme (14, 17, 18) eingelegt wird.

4. Verfahren nach einem der vorhergehenden Ansprüche, **dadurch gekennzeichnet, dass** zwischen Teile der Aufnahme und dem Plattenstapel (16) ein hochtemperaturfestes Isolationsmaterial eingelegt wird.

5. Verfahren nach einem der vorgehenden Ansprüche, **dadurch gekennzeichnet, dass** Anschlüsse in einem nachfolgenden Lötprozess angebracht werden, bei welchem die Löttemperatur niedriger ist, als beim vorangegangenen Lötprozess.

6. Verfahren nach einem der vorhergehenden Ansprüche, **dadurch gekennzeichnet, dass** auf die Platten (9, 10) vor dem Verpressen und Verlöten eine Lotschicht (8) aufgebracht wird.

7. Verfahren nach einem der vorhergehenden Ansprüche, **dadurch gekennzeichnet, dass** die Platten (9, 10) durch einen photolitographischen Strukturierungsprozess mit nachfolgendem Ätzprozess mit Ausnehmungen (11, 12, 13) versehen werden.

8. Verwendung des Verfahrens nach einem der vorhergehenden Ansprüche zur Herstellung eines Mikro-Wärmeübertragers.

## Claims

1. Process for producing a component from plates (9, 10) which are stacked on top of one another, soldered together and into at least some of which recesses (11, 12, 13) are introduced, in which process at least one layer of solder (8) is provided between the plates (9, 10) for a soldering diffusion process, **characterized in that** the plates (9, 10) with layers of solder (8) between them are stacked on top of one another and prior to the soldering diffusion process are pressed using a press tool, and **in that** during the soldering diffusion process the stack of plates (9, 10) and layers of solder (8) is acted on without the use of a press tool or with only a relatively low compressive force compared to the compressive force during preliminary pressing.

2. Process according to Claim 1, **characterized in that** the stack of plates (9, 10) and layers of solder (8) is weighted during the soldering diffusion operation with a weight which corresponds to a force that is lower than the compressive force required during pressing.

3. Process according to Claim 1 or 2, **characterized in that** the stack of plates (9, 10) and layers of solder (8) is placed into a receptacle (14, 17, 18) for the soldering diffusion process.

4. Process according to one of the preceding claims, **characterized in that** an insulation material which is able to withstand high temperatures is placed between parts of the receptacle and the plate stack (16).

5. Method according to one of the preceding claims, **characterized in that** connections are applied in a subsequent soldering process, in which the soldering temperature is lower than in the preceding soldering process.

6. Process according to one of the preceding claims, **characterized in that** a layer of solder (8) is applied to the plates (9, 10) prior to the pressing and soldering.

7. Process according to one of the preceding claims, **characterized in that** the plates (9, 10) are provided with recesses (11, 12, 13) by a photolithographic patterning process followed by an etching process.

8. Use of the process according to one of the preceding claims for producing a micro heat exchanger.

## Revendications

1. Procédé de fabrication d'un élément de construction à partir de plaques (9, 10) empilées les unes sur les autres et brasées entre elles et percées, au moins en partie, par des évidements (11, 12, 13), avec entre les plaques (9, 10) au moins une couche de brasure (8) pour un process de brasage par diffusion,
**caractérisé en ce que**
les plaques (9, 10), avec les couches de brasure (8) situées entre elles, sont empilées et soumises avant le process de brasage par diffusion à un pressage préalable exercé par un outil de presse, tandis que pendant le process de brasage par diffusion la pile constituée de plaques (9, 10) et de couches de brasure (8) est traitée sans intervention d'un outil de presse ou est seulement soumise à une action de pressage relativement petite par rapport à la force de pressage préalable.

2. Procédé de fabrication selon la revendication 1,
**caractérisé en ce que**
la pile constituée de plaques (9, 10) et de couches de brasure (8) est, pendant l'opération de brasure par diffusion, chargée par un poids correspondant à une force plus petite que la force de pression nécessaire pendant le pressage préalable.

3. Procédé de fabrication selon la revendication 1 ou 2,
**caractérisé en ce que**
pour la réalisation du process de brasage par diffusion, la pile constituée de plaques (9, 10) et de couches de brasure (8) est placée dans un réceptacle (14, 17, 18).

4. Procédé de fabrication selon une des revendications précédentes,
**caractérisé en ce qu'**
un matériau d'isolation résistant à de hautes températures est placé entre des parties du réceptacle et la pile (16) de plaques.

5. Procédé de fabrication selon une des revendications précédentes,
**caractérisé en ce que**
des raccords sont réalisés au cours d'un process de brasage ultérieur, à une température inférieure à celle du process de brasage antérieur.

6. Procédé de fabrication selon une des revendications précédentes,
**caractérisé en ce qu'**
une couche de brasure (8) est déposée sur les plaques (9, 10) avant le pressage préalable et le brasage.

7. Procédé de fabrication selon une des revendications précédentes,
**caractérisé en ce que**
les plaques (9, 10) sont munies d'évidements (11, 12, 13) réalisés selon un process de structuration photolithographique suivi d'un process de gravure.

8. Utilisation du procédé selon une des revendications précédentes, pour fabriquer un micro-échangeur de chaleur.
